# FASCICULE DE BREVET EUROPEEN

(11) **EP 1 852 003 B1**
(45) Date de publication et mention de la délivrance du brevet: **25.06.2014**
(21) Numéro de dépôt: 06709342.7
(22) Date de dépôt: 20.02.2006
(51) Int. Cl.: H05K 3/06, H05K 3/00, H01Q 1/38, H01Q 15/14, H01Q 15/16, H05K 1/02

(54) **PROCEDE POUR FORMER DES MOTIFS ELECTRIQUEMENT CONDUCTEURS SUR UN SUBSTRAT ISOLANT, ET DISPOSITIF OBTENU**
VERFAHREN ZUR HERSTELLUNG ELEKTRISCH LEITENDER MUSTER AUF EINEM ISOLIERSUBSTRAT UND SICH ERGEBENDE VORRICHTUNG
METHOD FOR FORMING ELECTRICALLY CONDUCTIVE PATTERNS ON AN INSULATING SUBSTRATE, AND RESULTING DEVICE

(30) Priorité: 23.02.2005 FR 0501816
(43) Date de publication de la demande: 07.11.2007
(73) Titulaire: ASTRIUM SAS, 75016 Paris (FR)
(72) Inventeur: DESAGULIER, Christian, F-75016 PARIS (FR); LACOMBE, Alain, F-78240 CHAMBOURCY (FR); ESMILLER, Bruno, F-78670 VILLENNES SUR SEINE (FR)
(74) Mandataire: Bonnetat, Christian
(86) Numéro de dépôt international: PCT/FR2006/000374
(87) Numéro de publication internationale: WO 2006/090051

(56) Documents cités:
- WO-A-2004/026977
- US-A1- 2004 017 408

## Description

La présente invention concerne un procédé pour la réalisation de motifs électriquement conducteurs sur une surface d'un substrat isolant.

Quoique non exclusivement, elle est particulièrement appropriée à la réalisation, sur une surface au moins approximativement en forme de paraboloïde, d'hyperboloïde, etc ... d'une grille de polarisation (antenne à réutilisation de fréquence) ou d'une série de motifs résonnants (antennes dichroïques). L'invention concerne aussi les dispositifs comportant un tel substrat dont ladite surface non développable porte lesdits motifs électriquement conducteurs, réalisés conformément au procédé.

On sait que, pour réaliser un circuit imprimé sur une face plane d'un substrat électriquement isolant, on commence par recouvrir uniformément ladite surface d'une couche d'un métal, tel que le cuivre ou l'aluminium, après quoi cette couche métallique est elle-même uniformément recouverte d'un produit photosensible. Ensuite, le produit photosensible est exposé à un faisceau lumineux, à travers un masque correspondant au circuit imprimé à obtenir. Une telle exposition rend chimiquement résistantes les parties du produit photosensible se trouvant à l'aplomb des parties de la couche métallique devant former le circuit imprimé, de sorte qu'une attaque chimique appropriée permet ensuite d'éliminer sélectivement les portions du produit photosensible qui n'ont pas été rendues chimiquement résistantes par l'exposition, ainsi que les portions de couche métallique se trouvant sous celles-ci.

A la suite de ladite attaque chimique, on obtient donc le circuit imprimé désiré.

Dans le cas où l'on désirerait appliquer cette méthode à la réalisation de circuits imprimés sur une surface non plus plane, mais non développable à trois dimensions, on se heurterait à des difficultés au moment de l'application du masque sur ladite surface. En effet, pour des raisons évidentes de commodité de réalisation et de précision, un tel masque est plan. Aussi, il faudrait soit découper ledit masque en pièces d'aires réduites et appliquer en les juxtaposant lesdites pièces sur ladite surface non développable, soit réaliser ledit masque en un matériau souple pouvant être appliqué par déformation sur celle-ci. Dans les deux cas, le circuit imprimé obtenu serait peu précis, aussi bien en ce qui concerne la forme que la position des motifs qui le composent.

On remarquera de plus que si, en variante, on réalise ledit circuit imprimé sur un substrat auxiliaire plan destiné à être appliqué ultérieurement sur la surface non développable, on se heurte aux mêmes difficultés que celles mentionnées ci-dessus à propos des masques.

Pour remédier à ces inconvénients et permettre de réaliser des circuits imprimés précis, directement sur des surfaces à trois dimensions non développables, on peut mettre en oeuvre le procédé décrit dans les documents US-4 738 746 ; EP-0 241 331 et FR-2 596 230. Dans ce procédé, tout comme dans celui rappelé ci-dessus, on commence par recouvrir uniformément ladite surface, alors non développable à trois dimensions, d'une couche d'une matière électriquement conductrice, que l'on recouvre à son tour d'une couche d'une matière de protection. Après formation desdites couches de matière conductrice et de matière de protection, on trace mécaniquement sur celles-ci le contour desdits motifs au moyen d'un outil creusant des sillons dont la profondeur est au moins égale à l'épaisseur de ladite couche de protection, puis on soumet lesdites couches à l'action d'un agent chimique susceptible d'attaquer sélectivement ladite matière électriquement conductrice sans attaquer ladite matière de protection, cette opération d'attaque chimique étant poursuivie pendant un temps suffisant pour que ladite matière électriquement conductrice soit éliminée sur toute son épaisseur à l'aplomb desdits sillons, après quoi on sépare du substrat, par pelage, les parties de ladite couche de matière électriquement conductrice extérieures auxdits motifs.

Ainsi, grâce à ce dernier procédé, on peut réaliser directement des motifs électriquement conducteurs sur des surfaces non développables à trois dimensions sans avoir recours à un masque ou un substrat auxiliaire avec lesquels, d'ailleurs, il serait techniquement difficile d'obtenir des motifs aussi précis tant au niveau de leur forme que de leur position sur lesdites surfaces.

Dans un tel procédé antérieur, pour le traçage des contours desdits motifs électriquement conducteurs, on utilise un outil pourvu d'au moins une pointe de gravure ou d'au moins une lame coupante, ledit outil étant monté dans une machine (par exemple à commande numérique et à cinq axes de rotation) chargée de le déplacer relativement à la surface non développable.

On peut ainsi réaliser des dispositifs à surface non développable portant des motifs électriquement conducteurs, de façon aisée et précise. Par exemple, la mise en oeuvre de ce procédé connu permet la réalisation de réflecteurs à grille de grande qualité, aptes à travailler dans la bande Ku (de 11 à 18 GHz) et formés d'au moins un réseau de fils conducteurs parallèles, ces fils conducteurs ayant une largeur de 0,25 mm, une épaisseur de 35 micromètres et étant répartis au pas de 1 mm sur une surface au moins approximativement en forme de paraboloïde, dont le diamètre d'ouverture peut atteindre 2300 mm.

Cependant, ce procédé antérieur présente des limites d'ordre technique et économique. Par exemple, si à la place d'un réflecteur à grille destiné à travailler dans la bande Ku, on désire réaliser un tel réflecteur destiné à la bande Ka (de 20 à 30 GHz), la largeur, l'épaisseur et le pas de répartition des fils conducteurs deviennent plus faibles (par exemple respectivement 0,125 mm, 18 micromètres et 0,5 mm) et il en résulte des difficultés dues à la plus faible largeur et à la plus faible épaisseur des fils conducteurs et des zones entre fils :
- les paramètres de traçage des motifs conducteurs (pression et disposition des pointes ou des lames de gravure) et les paramètres d'attaque chimique (durée) deviennent plus sensibles, de sorte qu'il en résulte des défauts géométriques et une fragilisation des fils conducteurs lors du pelage ;
- lors du traçage des fils conducteurs, les effets de bords deviennent significatifs, les pointes ou les lames repoussant, à la manière d'un soc, la matière conductrice d'épaisseur réduite et diminuant l'adhérence des fils conducteurs sur le substrat ; et
- les zones entre fils sont fragiles et sont donc susceptibles de se rompre lors du pelage.

Il en résulte que l'on doit veiller à ce que l'outil exerce un traçage toujours parfait et que le déroulement du procédé doit être ralenti, ce qui accroît les coûts de fabrication d'un tel réflecteur.

Par ailleurs, par le document WO 2004/026977, on connaît déjà un procédé permettant de réaliser des motifs électriquement conducteurs sur une surface d'un substrat électriquement isolant, procédé selon lequel :
- on recouvre uniformément ladite surface d'une couche d'une matière électriquement conductrice ;
- on forme sur ladite couche de matière électriquement conductrice, par projection d'un jet de matière de protection polymérisable sous l'action de radiations, un patron desdits motifs électriquement conducteurs, ledit patron étant pourvu d'ouvertures correspondant auxdites portions de ladite couche de matière électriquement conductrice à éliminer ; et
- on procède à l'élimination sélective des portions de ladite couche de matière électriquement conductrice, qui ne correspondent pas à des zones devant former lesdits motifs, à travers lesdites ouvertures du patron rigidifié, les zones de ladite couche de matière électriquement conductrice correspondant auxdits motifs étant protégées par ledit patron rigidifié pendant ladite élimination sélective.

Ainsi, un tel procédé connu s'apparente, en ce qui concerne la formation dudit patron, à l'impression par jet d'encre, de sorte que l'on s'affranchit de tout contact mécanique avec la couche de matière électriquement conductrice lors de la réalisation desdits motifs électriquement conducteurs, ce qui permet d'éviter les inconvénients mentionnés ci-dessus concernant le procédé conforme au document US-4 738 746.

Cependant, pour pouvoir être projetée, ladite matière de protection polymérisable doit être relativement fluide, de sorte que, une fois projetée sur ladite couche de matière électriquement conductrice, elle a tendance à couler et à s'étaler sur cette dernière, ce qui nuit à la précision dudit patron et donc à celle desdits motifs électriquement conducteurs.

La présente invention a pour objet de remédier à ces inconvénients.

A cette fin, selon l'invention, le procédé par projection de matière de protection polymérisable rappelé ci-dessus est remarquable en ce que, pour la formation et la rigidification dudit patron sur ladite couche de matière électriquement conductrice, on utilise une tête mobile d'impression par jet et une source mobile de radiations de polymérisation que l'on déplace de façon solidaire par rapport à ladite couche de matière électriquement conductrice pour couvrir toutes les zones de celle-ci devant former lesdits motifs électriquement conducteurs, la polymérisation de la matière de protection constituant ledit patron étant ainsi réalisée au fur et à mesure de la formation de celui-ci sur ladite couche de matière électriquement conductrice.

Ainsi, ledit patron est rigidifié au fur et à mesure de sa formation sur le substrat, de sorte qu'il peut être réalisé avec une grande précision.

De préférence, ladite matière de protection est du type polymérisable par un faisceau de radiations ultraviolettes. A titre d'exemple, une telle matière de protection peut être une résine qui contient des photoinitiateurs qui réticulent aux radiations UV, par exemple celle connue commercialement sous le nom de FUNJET ou de SERICOL.

Pour le déplacement solidaire de ladite tête d'impression et de ladite source de radiations, on peut avantageusement utiliser une machine semblable à celle mentionnée ci-dessus, prévue pour la mise en oeuvre du procédé antérieur du document US-4 738 746.

Ladite élimination sélective des portions de ladite couche de matière électriquement conductrice, qui ne correspondent pas auxdites zones devant former lesdits motifs, est réalisée à l'aide d'un agent chimique susceptible d'attaquer la matière électriquement conductrice sans attaquer ladite matière de protection.

De préférence, ledit agent chimique peut être du perchlorure de fer, lorsque ladite couche est en cuivre.

Après ladite élimination sélective des portions de ladite couche de matière électriquement conductrice qui ne correspondent pas à des zones devant former lesdits motifs électriquement conducteurs, on peut soit éliminer, soit laisser subsister ledit patron recouvrant lesdits motifs électriquement conducteurs.

De ce qui précède, on comprendra aisément que l'invention est particulièrement avantageuse à être mise en oeuvre pour la réalisation d'un dispositif, tel qu'un réflecteur par exemple, comportant un substrat électriquement isolant portant des motifs électriquement conducteurs sur une de ses surfaces non développable à trois dimensions. En effet, dans ce cas, quelle que soit la disposition dudit substrat pendant la projection du patron, des parties dudit substrat sont inclinées ou verticales, ce qui favoriserait l'écoulement et l'étalement de la matière projetée, si le motif n'était pas solidifié dès sa formation sur ladite surface.

Les figures du dessin annexé feront bien comprendre comment l'invention peut être réalisée. Sur ces figures, des références identiques désignent des éléments semblables.
La figure 1 représente schématiquement un dispositif d'antenne, dont le réflecteur est pourvu de motifs électriquement conducteurs réalisés par la mise en oeuvre du procédé conforme à la présente invention.
La figure 2 est une vue de face schématique agrandie d'une partie du réflecteur de la figure 1, illustrant la forme et la disposition desdits motifs électriquement conducteurs.
Les figures 3A à 3D illustrent schématiquement, en coupe, des étapes du procédé conforme à la présente invention, appliqué à la réalisation des motifs électriquement conducteurs des figures 1 et 2.

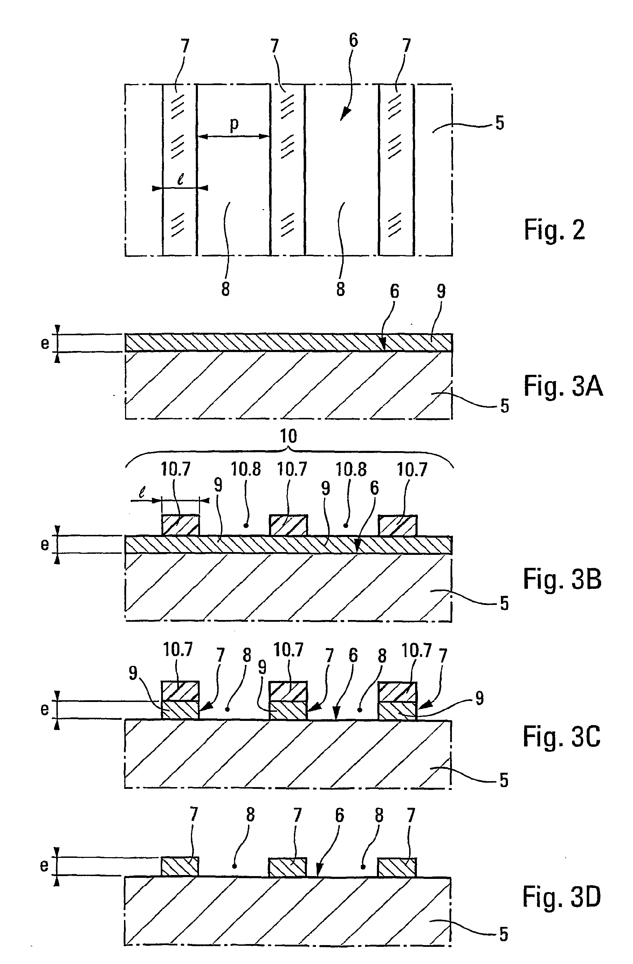

Sur les figures 2 et 3A à 3D, la surface du réflecteur portant lesdits motifs électriquement conducteurs, bien que concave et non développable, est représentée plane pour des facilités de dessin.

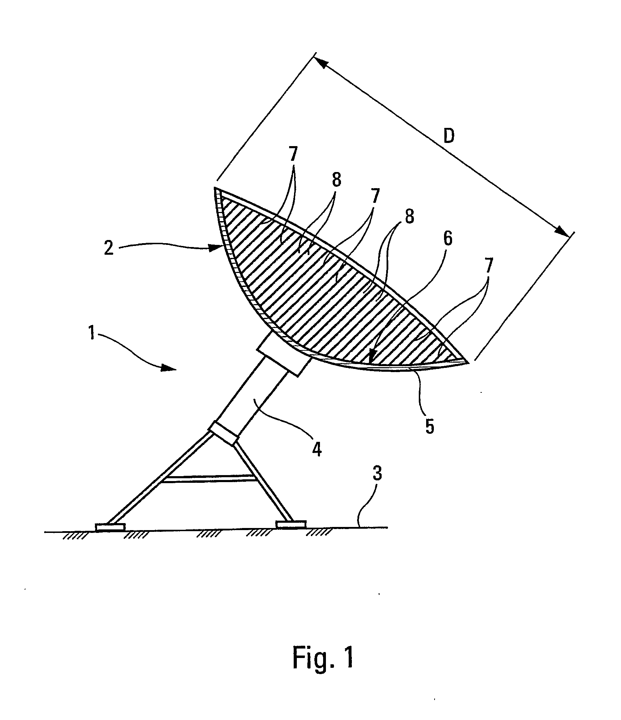

Sur la figure 1, on a représenté schématiquement un dispositif d'antenne 1 pourvu d'un réflecteur d'antenne 2 (représenté en coupe diamétrale), supporté par une surface d'appui 3, par l'intermédiaire d'un support 4.

Le réflecteur 2 comporte un substrat électriquement isolant 5 (par exemple réalisé en matériau composite), dont la surface 6 opposée au support 4 est concave et présente une forme non développable, par exemple la forme au moins approximative d'un paraboloïde, d'un hyperboloïde, etc ... Sur cette surface 6 non développable à trois dimensions, le réflecteur 2 porte des motifs électriquement conducteurs, formés, dans l'exemple représenté, par des conducteurs 7 parallèles les uns aux autres et équidistants. Chaque conducteur 7 présente une section rectangulaire de largeur ℓ et d'épaisseur e et le pas de répartition des conducteurs parallèles 7 est désigné par p. Ainsi, entre deux conducteurs 7 adjacents est ménagée une zone de séparation 8, en forme de bande ayant une largeur égale à p (voir également la figure 2).

Pour la réalisation du réflecteur 2 illustré schématiquement par les figures 1 et 2, on commence par recouvrir uniformément la surface non développable 6 du substrat 5 par une couche 9 d'une matière électriquement conductrice (voir la figure 3A) d'épaisseur égale à e. Une telle couche 9 peut, par exemple, être déposée sous vide sur la surface 6 ou être rapportée sur cette dernière par collage. Elle peut être métallique et par exemple constituée par du cuivre ou de l'aluminium.

Ensuite, à l'aide d'une tête de projection mobile, semblable à une tête d'impression par jet d'encre, on forme sur la couche de matière électriquement conductrice 9, un patron 10 desdits conducteurs à l'aide d'une matière de protection polymérisable. Comme le montre la figure 3B, ce patron 10 comporte, d'une part, des lignes de matière de protection 10.7, de largeur égale à ℓ, à l'aplomb des zones de la couche conductrice 9 devant former les conducteurs 7 et, d'autre part, entre lesdites lignes 10.7, des ouvertures 10.8 correspondant à des portions de la couche conductrice 9 à éliminer pour former les zones de séparation 8.

Au fur et à mesure du dépôt par projection des lignes 10.7 du masque 10 sur la couche conductrice 9, la matière desdites lignes 10.7 est polymérisée, de préférence à l'aide d'un faisceau de radiations ultraviolettes, afin de rigidifier ledit masque 10 dès sa formation. Pour ce faire, on utilise une source mobile de radiations de polymérisation que l'on déplace, de façon solidaire avec ladite tête de projection, par rapport à la couche de matière élastiquement conductrice 9.

Après une telle rigidification, on soumet la couche conductrice 9, à travers les ouvertures 10.8, à l'action d'un agent chimique, par exemple appliqué par projection ou par trempage.

Cet agent chimique attaque, entre les lignes 10.7, la couche de matière électriquement conductrice 9, sans attaquer lesdites lignes 10.7 de matière de protection. L'agent chimique, éliminant alors sélectivement la couche conductrice 9, est par exemple du perchlorure de fer, lorsque la couche 9 est en cuivre.

L'action de l'agent chimique sur la couche conductrice 9 est poursuivie jusqu'à ce que celle-ci soit éliminée sur toute son épaisseur à l'aplomb des zones de séparation 8 (figure 3C). Il en résulte la formation des conducteurs 7.

Ensuite, un rinçage est effectué sur l'ensemble du substrat 5 et de ladite couche 9 partiellement découpée.

Eventuellement, on procède de plus à l'élimination du masque 10 (lignes 10.7) recouvrant les conducteurs 7 (figure 3D). Cependant, la matière de protection du masque 10 peut être choisie pour posséder des caractéristiques qui la rende compatible de l'environnement (par exemple spatial) dans lequel le réflecteur sera appelé à travailler. Aussi, les lignes 10.7 du masque 10 peuvent alors subsister sur les conducteurs 7 et servir de protection à ceux-ci, par exemple contre la corrosion.

De ce qui précède, on remarquera que le procédé conforme à la présente invention est :
- économique et rapide, notamment du fait que la vitesse d'impression par jet peut être très rapide (par exemple 0,3 m/s) et que l'on peut utiliser plusieurs têtes d'impression simultanément ;
- réversible, puisqu'une erreur de programmation de la machine ou une anomalie d'impression peut être corrigée, l'impression pouvant reprendre après élimination au moins partielle de la matière de protection déjà projetée, sans altération du substrat 5 et de la couche conductrice 9 ;
- robuste, puisqu'il s'affranchit de la découpe mécanique de motifs très fins ; et
- versatile, puisqu'il permet la réalisation de motifs conducteurs de formes variées.

A titre d'exemple, on mentionne ci-après que la mise en oeuvre du procédé selon l'invention a permis de fabriquer un réflecteur tel que celui représenté sur les figures 1 et 2 avec ℓ = 0,125 mm, p = 0,5 mm et e =18 micromètres, le diamètre D de l'ouverture dudit réflecteur étant égal à 2300 mm.

## Revendications

1. Procédé permettant de réaliser des motifs électriquement conducteurs (7) sur une surface (6) d'un substrat électriquement isolant (5), procédé selon lequel :
- on recouvre uniformément ladite surface (6) d'une couche d'une matière électriquement conductrice (9) ;
- on forme sur ladite couche de matière électriquement conductrice (9), par projection d'un jet de matière de protection polymérisable sous l'action de radiations, un patron (10) desdits motifs électriquement conducteurs (7), ledit patron (10) étant pourvu d'ouvertures (10.8) correspondant auxdites portions de ladite couche de matière électriquement conductrice (9) à éliminer ;
- on procède à l'élimination sélective des portions de ladite couche de matière électriquement conductrice (9), qui ne correspondent pas à des zones devant former lesdits motifs (7), à travers lesdites ouvertures (10.8) du patron (10) rigidifié, les zones de ladite couche de matière électriquement conductrice (9) correspondant auxdits motifs (7) étant protégées par ledit patron (10) rigidifié pendant ladite élimination sélective,
**caractérisé en ce que**, pour la formation et la rigidification dudit patron (10) sur ladite couche de matière électriquement conductrice (9), on utilise une tête mobile d'impression par jet et une source mobile de radiations de polymérisation que l'on déplace de façon solidaire par rapport à ladite couche de matière électriquement conductrice (9) pour couvrir toutes les zones de celle-ci devant former lesdits motifs électriquement conducteurs (7), la polymérisation de la matière de protection constituant ledit patron (10) étant ainsi réalisée au fur et à mesure de la formation de celui-ci sur ladite couche de matière électriquement conductrice (9).

2. Procédé selon la revendication 1,
**caractérisé en ce que** ladite matière de protection est polymérisable sous l'action de radiations ultraviolettes.

3. Procédé selon la revendication 2,
**caractérisé en ce que** ladite matière de protection est une résine qui contient des photoinitiateurs qui réticulent sous l'action de radiations ultraviolettes.

4. Procédé selon l'une des revendications 1 à 3,
**caractérisé en ce que** ladite élimination sélective des portions de ladite couche de matière électriquement conductrice (9), qui ne correspondent pas auxdites zones devant former lesdits motifs (7), est réalisée à l'aide d'un agent chimique susceptible d'attaquer la matière électriquement conductrice sans attaquer ladite matière de protection.

5. Procédé selon la revendication 4,
**caractérisé en ce que** l'agent chimique éliminant ladite couche de matière conductrice (9) est du perchlorure de fer, lorsque ladite couche (9) est en cuivre.

6. Procédé selon l'une des revendications 1 à 5,
**caractérisé en ce que**, après ladite élimination sélective des portions de ladite couche de matière électriquement conductrice (9) qui ne correspondent pas à des zones devant former lesdits motifs (7), on élimine ledit patron (10) recouvrant lesdits motifs électriquement conducteurs (7).

7. Procédé selon l'une des revendications 1 à 5,
**caractérisé en ce que**, après ladite élimination sélective des portions de ladite couche de matière électriquement conductrice (9) qui ne correspondent pas à des zones devant former lesdits motifs (7), on laisse subsister ledit patron (10) recouvrant lesdits motifs électriquement conducteurs (7).

8. Dispositif comportant un substrat électriquement isolant (5) portant des motifs électriquement conducteurs (7) sur une de ses surfaces (6),
**caractérisé en ce que** lesdits motifs électriquement conducteurs (7) sont réalisés par la mise en oeuvre du procédé spécifié sous l'une des revendications 1 à 7.

9. Dispositif selon la revendication 8,
**caractérisé en ce que** ladite surface (6) portant lesdits motifs électriquement conducteurs (7) est non développable à trois dimensions.

## Patentansprüche

1. Verfahren zum Realisieren elektrisch leitender Muster (7) auf einer Oberfläche (6) eines elektrisch isolierenden Substrats (5), bei dem:
- die Oberfläche (6) gleichförmig mit einer Schicht aus einem elektrisch leitenden Material (9) abgedeckt wird;
- auf der Schicht aus elektrisch leitendem Material (9), durch Sprühen eines Strahls eines unter der Einwirkung von Strahlung polymerisierbaren Schutzmaterials, eine Schablone (10) der elektrisch leitenden Muster (7) aufgeformt wird, wobei die Schablone (10) mit Öffnungen (10.8) versehen ist, die den Teilen der Schicht aus elektrisch leitendem Material (9), die zu entfernen sind, entsprechen;
- das selektive Entfernen der Teile der Schicht aus elektrisch leitendem Material (9), die nicht Zonen entsprechen, welche die Muster (7) bilden sollen, durch die Öffnungen (10.8) der versteiften Schablone (10) hindurch erfolgt, wobei die Zonen der Schicht aus elektrisch leitendem Material (9), die den Mustern (7) entsprechen, während des selektiven Entfernens durch die versteifte Schablone (10) geschützt sind,
**dadurch gekennzeichnet, dass**, bei der Aufformung und der Versteifung der Schablone (10) auf der Schicht aus elektrisch leitendem Material (9) ein beweglicher Strahldruckkopf und eine bewegliche Polymerisationsstrahlungsquelle verwendet werden, die fest verbunden relativ zu der Schicht aus elektrisch leitendem Material (9) bewegt werden, um dessen sämtliche Zonen, welche die elektrisch leitenden Muster (7) bilden sollen, zu bedecken, wobei die Polymerisierung des Schutzmaterials, das die Schablone (10) bildet, Zug um Zug mit deren Aufformung auf der Schicht aus elektrisch leitendem Material (9) realisiert wird.

2. Verfahren nach Anspruch 1,
**dadurch gekennzeichnet, dass** das Schutzmaterial unter der Einwirkung von ultravioletter Strahlung polymerisierbar ist.

3. Verfahren nach Anspruch 2,
**dadurch gekennzeichnet, dass** das Schutzmaterial ein Harz ist, das Photoinitiatoren enthält, die unter der Einwirkung von ultravioletter Strahlung vernetzen.

4. Verfahren nach einem der Ansprüche 1 bis 3,
**dadurch gekennzeichnet, dass** das selektive Entfernen der Teile der Schicht aus elektrisch leitendem Material (9), die nicht den Zonen entsprechen, welche die Muster (7) bilden sollen, mit Hilfe eines Reagenz realisiert wird, das geeignet ist, das elektrisch leitende Material anzugreifen, ohne das Schutzmaterial anzugreifen.

5. Verfahren nach Anspruch 4,
**dadurch gekennzeichnet, dass** das Reagenz, das die Schicht aus elektrisch leitendem Material (9) entfernt, Eisenperchlorid ist, wenn die Schicht (9) aus Kupfer ist.

6. Verfahren nach einem der Ansprüche 1 bis 5,
**dadurch gekennzeichnet, dass**, nach dem selektiven Entfernen der Teile der Schicht aus elektrisch leitendem Material (9), die nicht Zonen entsprechen, welche die Muster (7) bilden sollen, die Schablone (10), welche die elektrisch leitenden Muster (7) abdeckt, entfernt wird.

7. Verfahren nach einem der Ansprüche 1 bis 5,
**dadurch gekennzeichnet, dass**, nach dem selektiven Entfernen der Teile der Schicht aus elektrisch leitendem Material (9), die nicht Zonen entsprechen, welche die Muster (7) bilden sollen, die Schablone (10), welche die elektrisch leitenden Muster (7) abdeckt, belassen wird.

8. Vorrichtung mit einem elektrisch isolierenden Substrat (5), das auf einer seiner Oberflächen (6) elektrisch leitende Muster (7) trägt,
**dadurch gekennzeichnet, dass** die elektrisch leitenden Muster (7) durch die Ausführung des unter Anspruch 1 bis 7 spezifizierten Verfahrens realisiert sind.

9. Vorrichtung nach Anspruch 8,
**dadurch gekennzeichnet, dass** die Oberfläche (6), welche die elektrisch leitenden Muster (7) trägt, nicht in drei Dimensionen abwickelbar ist.

## Claims

1. A method for producing electrically conductive patterns (7) on a surface (6) of an electrically insulating substrate (5), according to which method:
- said surface (6) is covered uniformly with a layer of an electrically conductive material (9);
- a template (10) of said electrically conductive patterns (7) is formed on said electrically conductive material layer (9) by spraying a jet of protective material which is polymerizable under the action of radiation, said template (10) being provided with openings (10.8) corresponding to said portions of said electrically conductive material layer (9) to be removed;
- the portions of said electrically conductive material layer (9) which do not correspond to zones intended to form said patterns (7) are removed selectively through said openings (10.8) of the rigidified template (10), the zones of said electrically conductive material layer (9) corresponding to said patterns (7) being protected by said rigidified template (10) during said selective removal,
**characterized in that**, in order to form and rigidify said template (10) on said electrically conductive material layer (9), a mobile jet printing head and a mobile source of polymerizing radiation are used which are moved together relative to said electrically conductive material layer (9) in order to cover all its zones intended to form said electrically conductive patterns (7), the protective material constituting said template (10) thus being polymerized as it is being formed on said electrically conductive material layer (9).

2. The method as claimed in claim 1, **characterized in that** said protective material is polymerizable under the action of ultraviolet radiation.

3. The method as claimed in claim 2, **characterized in that** said protective material is a resin which contains photoinitiators that crosslink under the action of ultraviolet radiation.

4. The method as claimed in one of claims 1 to 3, **characterized in that** said selective removal of the portions of said electrically conductive material layer (9), which do not correspond to said zones intended to form said patterns (7), is carried out with the aid of a chemical agent capable of attacking the electrically conductive material without attacking said protective material.

5. The method as claimed in claim 4, **characterized in that** the chemical agent which removes said conductive material layer (9) is iron perchloride, when said layer (9) is made of copper.

6. The method as claimed in one of claims 1 to 5, **characterized in that**, after said selective removal of the portions of said electrically conductive material layer (9), which do not correspond to said zones intended to form said patterns (7), said template (10) covering said electrically conductive patterns (7) is removed.

7. The method as claimed in one of claims 1 to 5, **characterized in that**, after said selective removal of the portions of said electrically conductive material layer (9), which do not correspond to said zones intended to form said patterns (7), said template (10) covering said electrically conductive patterns (7) is left in place.

8. A device comprising an electrically insulating substrate (5) carrying electrically conductive patterns (7) on one of its surfaces (6),
**characterized in that** said electrically conductive patterns (7) are produced by carrying out the method as specified in one of claims 1 to 7.

9. Device according to claim 8,
**characterized in that** said surface (6) carrying the electrically conductive patterns (7) is a non-developable three-dimensional surface.
